# EUROPÄISCHE PATENTSCHRIFT

(11) **EP 1 545 169 B1**
(45) Veröffentlichungstag und Bekanntmachung des Hinweises auf die Patenterteilung: **30.05.2012**
(21) Anmeldenummer: 04106224.1
(22) Anmeldetag: 01.12.2004
(51) Int. Cl.: H01H 11/00, H05K 3/22, H05K 1/02

(54) **Schaltermodul**
Switch module
Module d'interrupteur

(30) Priorität: 18.12.2003 DE 10361344
(43) Veröffentlichungstag der Anmeldung: 22.06.2005
(73) Patentinhaber: Valeo Schalter und Sensoren GmbH, 74321 Bietigheim-Bissingen (DE)
(72) Erfinder: Tornar, Roland, 86653, Mohnheim (DE); Weiss, Thomas, 74369, Löchgau (DE)
(74) Vertreter: Vötsch, Reiner

(56) Entgegenhaltungen:
- WO-A-00/25392
- DE-A1- 2 533 802
- DE-A1- 3 915 767

## Beschreibung

Die Erfindung betrifft ein Schaltermodul, insbesondere für eine Verwendung in Kraftfahrzeugen, mit einer Leiterbahnen aufweisenden Leiterplatte und mit mindestens einem relativ zur Leiterplatte positionierbaren Schalter. Derartige Schaltermodule können in Kraftfahrzeuge, beispielsweise in einen Armaturenträger eingebaut werden, um einer Bedienperson die Steuerung verschiedener Funktionen zu ermöglichen. Dabei kann jedem Schalter eine bestimmte Funktion zugewiesen sein, wie beispielsweise Warnblinkanlage, Defroster, Heckrollo etc.

Im Kraftfahrzeugbau besteht eine erhöhter Bedarf nach einer Individualisierung eines Kraftfahrzeugs. So können verschiedene Optionen oder Ausstattungspakete geordert werden, um das Kraftfahrzeug an die Wünsche eines Kunden anpassen zu können. Dabei bedingt eine erhöhte Anzahl von zur Verfügung stehenden Ausstattungsoptionen eine unüberschaubare Kombinationsvielfalt verschiedener Ausstattungsoptionen. Für die Montage eines Kraftfahrzeugs ergeben sich daraus erhebliche Schwierigkeiten. So ist die Produktionslogistik sehr komplex, wenn eine Vielzahl von unterschiedlich gestalteten Schaltermodulen bereit gestellt werden müssen, um allen Ausstattungswünschen bzw. allen Kombinationen von Ausstattungswünschen Rechnung tragen zu können.

Es besteht die Möglichkeit, programmierbare Schaltermodule zu verwenden, wobei die Zuweisung der Funktion eines Schalters durch die Programmierung des Schaltermoduls erfolgt. Dies hat jedoch den Nachteil, dass die Programmierung zeitaufwendig und fehleranfällig ist und auch eine Wartung oder Reparatur nur mit Hilfe spezieller Programmiergeräte möglich ist.

Aus der WO 00/25392 A ist ein Schaltermodul mit den Merkmalen des Oberbegriffs des Anspruchs 1 bekannt. Bei diesem Schaltermodul werden Leiterbahnen mittels eines Codierungselements miteinander verbunden, wobei je nach Gestaltung des Codierungselements verschiedene Verbindungen zwischen den Leiterbahnen hergestellt werden können.

Aufgabe der Erfindung ist es, verschiedene Verbindungsvarianten zwischen Leiterbahnen einer Leiterplatte nicht durch ein Codierungselementzu ermöglichen, das diese Verbindungen erst herstellt, sondern es ermöglicht, eine Leiterplatte zu verwenden, die bereits die für alle Varianten erforderlichen Verbindungen zwischen den Leiterbahnen vollständig aufweist.

Diese Aufgabe wird mit einem Schaltermodul mit den Merkmalen des Anspruchs 1 gelöst.

Durch die erfindungsgemäße Codierung kann eine für alle Kombinationen von Ausstattungswünschen identische Leiterblatte verwendet werden. Das Layout der Leiterbahnen der Leiterplatte wird durch das Codierungselement schalterspezifisch verändert.

Der Schalter kann direkt an der Leiterplatte montierbar sein oder an einer separaten Halterung. Somit kann entweder ein Schaltermodul mit Leiterplatte und Schalter der Montage eines Kraftfahrzeugs zugeführt werden, oder die genannten Bauteile können dem Kraftfahrzeug separat zugeführt werden. Als Halterung kommt beispielsweise ein Rahmen oder eine Blende in Betracht.

Der Aufnahmeabschnitt kann als zylindrische Öffnung ausgebildet sein. Diese lässt sich somit, beispielsweise durch Bohren oder Stanzen, besonders leicht herstellen.

Der Schalter kann auf der einer Bedienperson zugewandten Seite eine Beschriftung und/oder Symbolik aufweisen. Diese Beschriftung oder Symbolik kann als Zusatzelement oder in einen Schalter bereits integriert vorgesehen sein. Entsprechend kann der Schalter eine Beleuchtung aufweisen, die beispielsweise die Beschriftung und/oder Symbolik hinterleuchtet.

Nach einer vorteilhaften Ausführungsform der Erfindung ist die Anordnung des Codierungselements oder der Codierungselemente variabel. Dies bedeutet, dass ein Schalter mindestens ein Codierungselement aufweist, das relativ zum Schalter verschiedene Lagen einnehmen kann. Beispielsweise weist der Schalter verschiedene Rastaufnahmen auf, in die ein Codierungselement oder mehrere Codierungselemente einrastbar sind. Durch das hierdurch entstehende Codiermuster kann ein funktionsspezifischer Schalter hergestellt werden, der wiederum bei Montage und/oder Erstbetätigung des Schalters das Layout der Leiterplatte schalterspezifisch beeinflusst.

Natürlich kann auch die Anzahl der Codierungselemente eines Schalter variabel sein, so dass auch hierdurch eine Codierung eines Schalters erzeugbar ist.

Besonders vorteilhaft ist es, wenn mehrere Schalter vorgesehen sind, die sich hinsichtlich der Gestalt und/oder Anordnung und/oder Anzahl eines oder mehrere Codierungselemente unterscheiden. Somit können mehrere Schalter mit dem Schaltermodul zusammenwirken, wobei durch die funktionsspezifische Codierung jedes Schalters das Layout der Leiterplatte veränderbar ist.

Das Schaltermodul umfasst vorteilhafterweise eine elektrische Auswerteeinheit, die zur Identifizierung eines montierten Schalters dient. Da der montierte Schalter eine funktionsspezifische Codierung trägt, die das Layout der Leiterplatte entsprechend beeinflusst, kann in einem folgenden Schritt die Leiterplatte mit Strom beaufschlagt werden, so dass durch Auswertung von bestimmten Spannungs- bzw. Stromzuständen von Bereichen der Leiterplatte feststellbar ist, in welcher Weise der codierte Schalter das Layout der Leiterplatte verändert hat.

Anstelle des oder zusätzlich zum mindestens einen Schalters kann auch ein Anzeigeelement verwendet sein, das keine schaltende Betätigung erlaubt. Das Anzeigeelement kann zur Darstellung von Betriebszuständen eines Kraftfahrzeugs dienen, bspw. des Belegungszustands eines Kraftfahrzeugsitzes. Das Anzeigeelement durchtrennt bei seiner Montage mit seinem mindestens einen Codierungselement mindestens eine Leiterbahn der zugeordneten Leiterplatte oder stellt einen elektrischen Kontakt zwischen verschiedenen Leiterbahnen oder Leiterbahnabschnitten her. Auf diese Weise kann das Anzeigeelement das Layout der Leiterbahnen der Leiterplatte anzeigeelementspezifisch verändern.

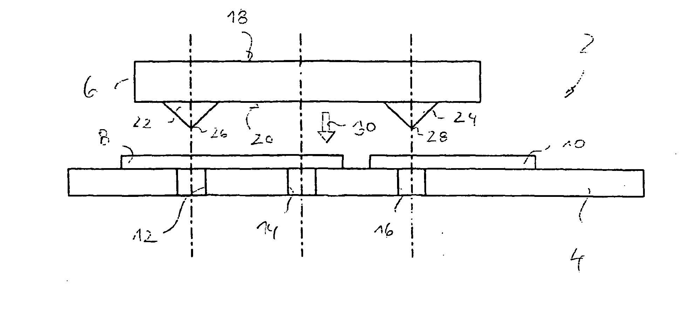

Weitere vorteilhafte Ausgestaltungen und Einzelheiten der Erfindung sind der folgenden Beschreibung zu entnehmen, in der die Erfindung anhand des in der Zeichnung dargestellten Ausführungsbeispiels näher beschrieben und erläutert ist.

Die einzige Figur zeigt ein Schaltermodul 2 mit einer Leiterplatte 4 sowie einem Schalter 6. Die Leiterplatte 4 trägt eine erste Leiterbahn 8 und eine zweite Leiterbahn 10.

Benachbart zu den Leiterbahnen 8 und 10 sind in der Leiterplatte 4, dem Schalter 6 abgewandt, ein erster Aufnahmeabschnitt 12 und ein zweiter Aufnahmeabschnitt 14 vorgesehen, die in der Zeichnung unterhalb der Leiterbahn 8 angeordnet sind. Entsprechend ist ein dritter Aufnahmeabschnitt 16 vorgesehen, der in der Zeichnung unterhalb der Leiterbahn 10 angeordnet ist.

Der Schalter 6 weist eine einer Bedienperson zugewandte Seite 18 auf, auf der eine (in der Zeichnung nicht dargestellte) Beschriftung und/oder Symbolik vorgesehen ist. Auf der einer Bedienperson abgewandten Seite 20 des Schalters 6 sind zwei Vorsprünge 22 und 24 vorgesehen. Die Oberflächen der Vorsprünge 22 und 24 laufen in Richtung auf die Leiterplatte 4 spitz zu, so dass Trennkanten 26 und 28 gebildet sind.

Wird der Schalter 6 entsprechend mit 30 bezeichneter Montagerichtung auf die Leiterplatte 4 aufgesetzt, durchtrennen die Trennkanten 26 und 28 die Bereiche der Leiterbahnen 8 und 10 oberhalb der Aufnahmeabschnitte 12 und 16. Im montierten Zustand können die Vorsprünge 22 und 24 in den Aufnahmeabschnitten 12 und 16 aufgenommen sein.

Durch das Aufsetzen des Schalters 6 bleibt die Leiterbahn 8 im Bereich des Aufnahmeabschnitts 14 unverändert.

Die Vorsprünge 22 und 24 bilden schalterspezifische Codierungselemente, so dass das Layout der Leiterbahnen 8 und 10 der Leiterplatte 4 schalterspezifisch beeinflussbar ist.

## Patentansprüche

1. Schaltermodul (2), insbesondere für eine Verwendung in Kraftfahrzeugen, mit einer Leiterbahnen (8, 10) aufweisenden Leiterplatte (4), mit mindestens einem relativ zur Leiterplatte (4) positionierbaren Schalter (6) und mit mindestens einem Codierungselement (22, 24) zur Festlegung von elektrischen Verbindungen zwischen den Leiterbahnen (8, 10), **dadurch gekennzeichnet, dass** das Codierungselement (22, 24) bei der Montage und/oder Erstbetätigung des Schalters (6) mindestens eine Leiterbahn (8, 10) durchtrennt, dass das Codierungselement (22, 24) eine Trennkante (26, 38) aufweist, dass das Codierungselement (22, 24) aus einem elektrisch nicht leitendem Material, insbesondere aus Kunststoff, hergestellt ist und dass die Leiterplatte (4) mindestens einen Aufnahmeabschnitt (12, 14, 16) aufweist, in dem mindestens ein Codierungselement (22, 24) zumindest abschnittsweise aufnehmbar ist.

2. Schaltermodul (2) nach Anspruch 1, **dadurch gekennzeichnet, dass** der Schalter (6) an der Leiterplatte (4) montierbar ist.

3. Schaltermodul (2) nach Anspruch 1 oder 2, **dadurch gekennzeichnet, dass** eine Halterung vorgesehen ist, in oder an der der Schalter (6) montierbar ist.

4. Schaltermodul (2) nach mindestens einem der vorhergehenden Ansprüche, **dadurch gekennzeichnet, dass** das Codierungselement (22, 24) als Vorsprung ausgebildet ist.

5. Schaltermodul (2) nach Anspruch 1, **dadurch gekennzeichnet, dass** der Aufnahmeabschnitt (12, 14, 16) als zylindrische Öffnung ausgebildet ist.

6. Schaltermodul (2) nach mindestens einem der vorhergehenden Ansprüche, **dadurch gekennzeichnet, dass** der Schalter (6) auf der einer Bedienperson zugewandten Seite (18) eine Beschriftung und/oder Symbolik aufweist.

7. Schaltermodul (2) nach mindestens einem der vorhergehenden Ansprüche, **dadurch gekennzeichnet, dass** der Schalter (6) eine Beleuchtung aufweist.

8. Schaltermodul (2) nach mindestens einem der vorhergehenden Ansprüche, **dadurch gekennzeichnet, dass** die Anordnung des Codierungselements (22, 24) oder der Codierungselemente (22, 24) variabel ist.

9. Schaltermodul (2) nach mindestens einem der vorhergehenden Ansprüche, **dadurch gekennzeichnet, dass** die Anzahl der Codierungselemente (22, 24) eines Schalters (6) variabel ist.

10. Schaltermodul (2) nach mindestens einem der vorhergehenden Ansprüche, **dadurch gekennzeichnet, dass** mehrere Schalter (6) vorgesehen sind, die sich hinsichtlich der Gestalt und/oder Anordnung und/oder Anzahl eines oder mehrerer Codierungselemente (22, 24) unterscheiden.

11. Schaltermodul (2) nach mindestens einem der vorhergehenden Ansprüche, **dadurch gekennzeichnet, dass** eine elektronische Auswerteeinheit zur Identifizierung eines montierten Schalters (6) vorgesehen ist.

12. Schaltermodul (2) nach mindestens einem der vorhergehenden Ansprüche, **dadurch gekennzeichnet, dass** anstelle des oder zusätzlich zum mindestens einen Schalters (6) ein Anzeigeelement verwendet ist.

13. Verfahren zur Herstellung eines Schaltermoduls (2), insbesondere eines Schaltermoduls (2) nach einem der vorhergehenden Ansprüche, **gekennzeichnet durch** die folgenden Verfahrensschritte:
- es wird eine Leiterbahnen (8, 10) aufweisende Leiterplatte (4) bereitgestellt,
- es wird ein Schalter (6) bereitgestellt, der mindestens ein Codierungselement (22, 24) aufweist,
- der Schalter (6) wird relativ zur Leiterplatte (4) positioniert, so dass das Codierungselement (22, 24) in Richtung auf die Leiterplatte (4) weist,
- mit Hilfe des Codierungselements (22, 24) wird mindestens eine Leiterbahn (8, 10) durchtrennt.

14. Verfahren nach Anspruch 13, **dadurch gekennzeichnet, dass** mindestens eine Leiterbahn (8, 10) bei Montage des Schalters (6) oder durch eine Erstbetätigung des montierten Schalters (6) durchtrennt wird.

15. Verfahren nach einem der Ansprüche 13 oder 14, **dadurch gekennzeichnet, dass** der Schalter (6) auf die Leiterplatte (4) montiert wird.

16. Verfahren nach einem der Ansprüche 13 bis 15, **dadurch gekennzeichnet, dass** der Schalter (6) in oder auf einer Halterung montiert wird.

17. Verfahren nach einem der Ansprüche 13 bis 16, **dadurch gekennzeichnet, dass** anstelle des oder zusätzlich zum mindestens einen Schalters (6) ein Anzeigeelement verwendet wird.

## Claims

1. Switch module (2), in particular for a use in motor vehicles, comprising a printed circuit board (4) having conductor tracks (8, 10), comprising at least one switch (6) which can be positioned relative to the printed circuit board (4), and comprising at least one coding element (22, 24) for defining electrical connections between the conductor tracks (8, 10), **characterized in that** the coding element (22, 24) severs at least one conductor track (8, 10) during the mounting and/or first actuation of the switch (6), **in that** the coding element (22, 24) has a separating edge (26, 38), **in that** the coding element (22, 24) is produced from an electrically non-conductive material, in particular from plastic, and **in that** the printed circuit board (4) has at least one receptacle section (12, 14, 16) in which at least one coding element (22, 24) can be received at least in sections.

2. Switch module (2) according to Claim 1, **characterized in that** the switch (6) can be mounted on the printed circuit board (4).

3. Switch module (2) according to Claim 1 or 2, **characterized in that** a mount is provided, in or non which the switch (6) can be mounted.

4. Switch module (2) according to at least one of the preceding claims, **characterized in that** the coding element (22, 24) is embodied as a projection.

5. Switch module (2) according to Claims 1, **characterized in that** the receptacle section (12, 14, 16) is embodied as a cylindrical opening.

6. Switch module (2) according to at least one of the preceding claims, **characterized in that** the switch (6) has an encryption and/or symbolism on the side (18) facing an operator.

7. Switch module (2) according to at least one of the preceding claims, **characterized in that** the switch (6) has an illumination.

8. Switch module (2) according to at least one of the preceding claims, **characterized in that** the arrangement of the coding element (22, 24) or of the coding elements (22, 24) is variable.

9. Switch module (2) according to at least one of the preceding claims, **characterized in that** the number of coding elements (22, 24) of a switch (6) is variable.

10. Switch module (2) according to at least one of the preceding claims, **characterized in that** a plurality of switches (6) are provided, which differ with regard to the shape and/or arrangement and/or number of one or a plurality of coding elements (22, 24).

11. Switch module (2) according to at least one of the preceding claims, **characterized in that** provision is made of an electronic evaluation unit for identifying a mounted switch (6).

12. Switch module (2) according to at least one of the preceding claims, **characterized in that** a display element is used instead of or in addition to the at least one switch (6).

13. Method for producing a switch module (2), in particular a switch module (2) according to any of the preceding claims, **characterized by** the following method steps:
- a printed circuit board (4) having conductor tracks (8, 10) is provided,
- a switch (6) is provided, which has at least one coding element (22, 24),
- the switch (6) is positioned relative to the printed circuit board (4), such that the coding element (22, 24) points in the direction of the printed circuit board (4),
- at least one conductor track (8, 10) is severed with the aid of the coding element (22, 24).

14. Method according to Claim 13, **characterized in that** at least one conductor track (8, 10) is severed during the mounting of the switch (6) or by a first actuation of the mounted switch (6).

15. Method according to either of Claims 13 and 14, **characterized in that** the switch (6) is mounted onto the printed circuit board (4).

16. Method according to any of Claims 13 to 15, **characterized in that** the switch (6) is mounted in or on a mount.

17. Method according to any of Claims 13 to 16, **characterized in that** a display element is used instead of or in addition to the at least one switch (6).

## Revendications

1. Module à commutateur (2), notamment destiné à être utilisé dans des véhicules automobiles, comprenant un circuit imprimé (4) présentant des pistes conductrices (8, 10), comprenant au moins un commutateur (6) positionnable par rapport au circuit imprimé (4) et comprenant au moins un élément de codage (22, 24) pour définir des liaisons électriques entre les pistes conductrices (8, 10), **caractérisé en ce que** l'élément de codage (22, 24) sectionne au moins une piste conductrice (8, 10) lors du montage et/ou du premier actionnement du commutateur (6), **en ce que** l'élément de codage (22, 24) présente une arête de sectionnement (26, 38), **en ce que** l'élément de codage (22, 24) est fabriqué dans un matériau non conducteur d'électricité, notamment en matière plastique, et **en ce que** le circuit imprimé (4) présente au moins une première section d'accueil (12, 14, 16) dans laquelle peut être accueilli au moins partiellement au moins un élément de codage (22, 24).

2. Module à commutateur (2) selon la revendication 1, **caractérisé en ce que** le commutateur (6) peut être monté sur le circuit imprimé (4).

3. Module à commutateur (2) selon la revendication 1 ou 2, **caractérisé en ce qu'**il est prévu un support dans ou sur lequel peut être monté le commutateur (6).

4. Module à commutateur (2) selon au moins l'une des revendications précédentes, **caractérisé en ce que** l'élément de codage (22, 24) est réalisé sous la forme d'une partie en saillie.

5. Module à commutateur (2) selon la revendication 1, **caractérisé en ce que** la section d'accueil (12, 14, 16) est réalisée sous la forme d'une ouverture cylindrique.

6. Module à commutateur (2) selon au moins l'une des revendications précédentes, **caractérisé en ce que** le commutateur (6) présente un marquage et/ou un pictogramme sur le côté (18) qui fait face à un opérateur.

7. Module à commutateur (2) selon au moins l'une des revendications précédentes, **caractérisé en ce que** le commutateur (6) présente un éclairage.

8. Module à commutateur (2) selon au moins l'une des revendications précédentes, **caractérisé en ce que** la disposition de l'élément de codage (22, 24) ou des éléments de codage (22, 24) est variable.

9. Module à commutateur (2) selon au moins l'une des revendications précédentes, **caractérisé en ce que** le nombre d'éléments de codage (22, 24) d'un commutateur (6) est variable.

10. Module à commutateur (2) selon au moins l'une des revendications précédentes, **caractérisé en ce que** plusieurs commutateurs (6) sont prévus, lesquels se différencient du point de vue de la configuration et/ou de la disposition et/ou du nombre d'un ou plusieurs éléments de codage (22, 24).

11. Module à commutateur (2) selon au moins l'une des revendications précédentes, **caractérisé en ce qu'**il est prévu une unité d'interprétation électronique pour identifier un commutateur (6) monté.

12. Module à commutateur (2) selon au moins l'une des revendications précédentes, **caractérisé en ce qu'**un élément indicateur est utilisé à la place de l'au moins un commutateur (6) ou en complément de celui-ci.

13. Procédé de fabrication d'un module à commutateur (2), notamment un module à commutateur (2) selon l'une revendications précédentes, **caractérisé par** les étapes suivantes :
- un circuit imprimé (4) présentant des pistes conductrices (8, 10) est fourni,
- un commutateur (6) comprenant au moins un élément de codage (22, 24) est fourni,
- le commutateur (6) est positionné par rapport au circuit imprimé (4) de telle sorte que l'élément de codage (22, 24) est orienté en direction du circuit imprimé (4),
- au moins une piste conductrice (8, 10) est sectionnée à l'aide de l'élément de codage (22, 24).

14. Procédé selon la revendication 13, **caractérisé en ce qu'**au moins une piste conductrice (8, 10) est sectionnée lors du montage du commutateur (6) ou par un premier actionnement du commutateur (6) monté.

15. Procédé selon l'une des revendications 13 ou 14, **caractérisé en ce que** le commutateur (6) est monté sur le circuit imprimé (4).

16. Procédé selon l'une des revendications 13 à 15, **caractérisé en ce que** le commutateur (6) est monté dans ou sur un support.

17. Procédé selon l'une des revendications 13 à 16, **caractérisé en ce qu'**un élément indicateur est utilisé à la place de l'au moins un commutateur (6) ou en complément de celui-ci.
